# EUROPEAN PATENT APPLICATION

(11) **EP 4 016 188 A2**
(43) Date of publication of application: **22.06.2022**
(21) Application number: 21215418.1
(22) Date of filing: 17.12.2021
(51) Int. Cl.: G03F 7/20

(54) **PROCESS AND APPARATUS FOR CONTROLLED EXPOSURE OF FLEXOGRAPHIC PRINTING PLATES**

(30) Priority: 18.12.2020 US 202063127292 P
(71) Applicant: Esko-Graphics Imaging GmbH, 25524 Itzehoe (DE)
(72) Inventor: SIEVERS, Wolfgang, 25569 Kremperheide (DE)
(74) Representative: Müller-Boré & Partner Patentanwälte PartG mbB

(57) **Abstract**

An apparatus for preparing a photosensitive polymer printing plate includes a front source with an irradiation field covering an area at least coextensive with a first dimension of the front of the plate, at least one back source with an irradiation field covering an area coextensive with the back side of the plate, and a holder configured to receive the printing plate to receive the radiation. The front source and the printing plate move relative to one another and a non-irradiated area of the back side of the printing plate moves relative to the plate within an otherwise irradiated area coextensive with the back side of the plate. A controller controls the front source and the non-irradiated area so that no cross-sectionally aligned, opposing portions of the front side and back side of the plate receive irradiation simultaneously from the front and the back.

## Description

### BACKGROUND OF THE INVENTION

Many processes are known in the art for preparing polymer printing plates, such as photopolymer flexographic plates and letterpress printing plates coated with photopolymer material. One known process starts with a plate having an ablatable material thereon, imaging the plate in a digital imager to ablate the ablatable material according to imaging data, and then curing the exposed plate by exposure of the plate to radiation, such as light energy, including but not limited to ultraviolet (UV) light energy.

Various processes for curing the plate on both the imaged side and the back side of the plate by exposure to a functional energy source are known, including methods for providing a blanket exposure (such as with fluorescent light tubes that emit UV light), and methods for providing the desired radiation using light emitting diode (LED) technology, such as is described in U.S. Patent No. 8,389,203, assigned to the assignee of the present application and incorporated by reference in its entirety. One particularly useful LED arrangement is shown and described in U.S. Pat. No. 8,578,854, also incorporated herein by reference.

One prior art process involves exposing the back of a plate, then performing laser ablation on the front side of the plate, then performing front side exposure. This process interposes an undefined, variable time delay between the first and second exposure, depending upon the amount of time for the laser ablation step. This variability in elapsed time between first and second exposure leads to undesirable variability in plate quality. Still other processes may include exposing both the back side and the front side of a plate simultaneously, which although it produces more predictable results than a process that imposes a variable time delay, may still be less than optimal in certain configurations, as discussed more herein later. Particularly suitable exposure processes and apparatus are shown and described in U.S. Pat. No. 10,732,507, incorporated herein by reference.

The radiation power required for the backside exposure is typically in a range between 20 mW/cm² (which is a typical irradiance produces by older conventional bank exposure units operating with fluorescent tubes) up to 100 mW/cm². The irradiance for front exposure may reach 300 to 800 mW/cm². This high intensity is required in order to create flat top dots on conventional digital flexographic printing plates. However, due to the high main exposure intensities and the high number of UV LED required for a full exposure of plate 101, main exposure sources be may limited to being designed as "linear" radiation sources, while back exposure sources may be designed as full-plate radiation sources, as described in greater detail below.

The above configuration has some disadvantages. First and foremost, the long exposure time required by the linear head exposes all plate segments in a consecutive manner. The smaller the ratio between irradiation area of the emitting surface of the main exposure head and the plate surface, the longer it takes for a complete front exposure. Moreover, the mechanics required for the relative movement and their control electronics increase the overall costs and complexity of the system.

Another problem is back-reflection of the front exposure UV light contributing to back exposure intensity. In some cases, less than all of the front exposure UV light is absorbed by the polymer. A part of the front UV light exits the plate at the rear side and can be back reflected towards the rear side of the plate, contributing to backside exposure. As the amount of transmitted light is depending on the ratio between mask openings and non-ablated mask, the amount of back reflected light is not constant. This can cause undesired effects on the floor thickness. For example, in regions of the plate with a lot of removed LAMs (Laser Ablateable Mask) layer, the floor may grow higher than in regions with only little or no removed LAMs layer. This effect gets stronger when front exposure and back exposure are applied at the same time.

In view of the above, improved processes and apparatus for controlled exposure of printing plates are desired.

### SUMMARY OF THE INVENTION

One aspect of the invention relates to an apparatus for preparing a printing plate comprising a photosensitive polymer activated by exposure to radiation, the printing plate having a non-printing back side and a printing front side with a mask for defining an image to be printed. The apparatus comprises a plurality of radiation sources comprising at least one front source positioned to expose the front side of the plate to radiation and at least one back source positioned to expose the back side of the plate to radiation. The at least one front source has an irradiation field covering an area at least coextensive with a first dimension of the front side of the plate. The at least one back source has an irradiation field covering an area coextensive with the back side of the plate. A holder is configured to receive the printing plate in a position to receive the radiation from the plurality of radiation sources. Means is provided for causing relative movement (i) between the at least one front source and the printing plate in a movement direction orthogonal to the first dimension and (ii) between the plate and a non-irradiated area of the back side of the printing plate in the movement direction within an otherwise irradiated area coextensive with the back side of the plate. A controller is configured to operate the plurality of radiation sources to expose the plate to the radiation, and to operate the means for causing relative movement, such that no cross-sectionally aligned, opposing portions of the front side and back side of the plate receive irradiation simultaneously from the at least one front source and the at least one back source.

In embodiments, the at least one back source comprises an array of sub-sources, and the controller is configured to operate the at least one front source to irradiate the front side of the plate along the movement direction, and to activate and inactivate a variable set of the sub-sources of the at least one back source synchronized with the relative motion of the at least one front source to cause irradiation of the back side of the printing plate except for in the non-irradiated area. At least a portion of the non-irradiated area is cross-sectionally aligned with the opposing portion of the front side of the plate simultaneously irradiated by the at least one front source.

Other embodiments include a radiation shield opaque to the radiation from the plurality of radiation sources, the radiation shield positioned between at least a portion of the printing plate and at least a portion of the at least one back source, and means for causing relative movement between the radiation shield and the printing plate. In such embodiments, the controller is further configured to cause a first relative movement between the at least one front source and the printing plate in the movement direction, and to simultaneously cause a second relative movement between the radiation shield and the printing plate in the movement direction. The radiation shield may have a length extending in the movement direction beyond the irradiation field of the at least one front source. The length of the radiation shield may be adjustable in the movement direction. The radiation shield may be reconfigurable between a first state in which the radiation shield blocks a first percentage of the radiation from the at least one back source and a second state in which the radiation shield blocks a second percentage of the radiation from the at least one back source, wherein the first percentage is greater than the second percentage, such as where the first percentage is a maximum blocking percentage and the second percentage is a minimum blocking percentage. In one embodiment, the radiation shield comprises a plurality of louvers movable between a first configuration in which each louver blocks a maximum percentage of radiation between the at least one back source and the printing plate, and a second configuration in which each louver blocks a minimum percentage of radiation between the at least one back source and the printing plate.

In embodiments, the radiation shield may comprise two panels serially disposed between the at least one back source and the back side of the printing plate, the two panels defining an overlapping region in which respective portions of both panels are disposed between the at least one back source and the back side of the printing plate and at least one non-overlapping region in which only one of the two panels is disposed between the least one back source and the back side of the printing plate. At least one panel is laterally adjustable relative to the other panel to adjust an overall effective length of the radiation shield in which at least one panel is disposed between the at least one back source and the back side of the printing plate.

In embodiments, the radiation shield comprises at least two panels serially disposed between the at least one back source and the back side of the printing plate, the at least two panels defining an overlapping region in which respective portions of the panels are disposed between the at least one back source and the back side of the printing plate. Each of the at least two panels has one or more linear perforations extending across at least a portion of the first dimension, at least one of the at least two panels being laterally adjustable between the first state in which respective perforations of the panels are aligned and the second state in which the respective perforations of the patents are not aligned.

The means for causing relative movement may include a first means for causing relative movement between the at least one front radiation source and the printing plate and a second means for causing relative movement between the radiation shield and the printing plate. The means for causing relative movement may include at least one driving motor, with one or more components linking the first means and the second means selected from the group consisting of Bowden cables, magnetic elements, belts, or chains. In some embodiments, the first means and the second means are independent from one another, and the controller is configured to synchronize the first means and the second means.

The one or more radiation sources may comprise a plurality of LED point sources configured to emit UV light. The radiation shield may comprise a UV-absorbing coating. The holder may comprise a substrate on which the plate is disposed, wherein the substrate is at least partially transparent to the radiation.

Another aspect of the invention relates to a process for exposing a printing plate comprising a photosensitive polymer activated by exposure to radiation from a plurality of radiation sources, the printing plate having a non-printing back side and a printing front side with a mask for defining an image to be printed. The plurality of radiation sources include at least one front source positioned to expose the front side of the plate to radiation and at least one back source positioned to expose the back side of the plate to radiation. The at least one front source has an irradiation field covering an area at least coextensive with a first dimension of the front side of the plate. The at least one back source has an irradiation field covering an area coextensive with the back side of the plate. The method comprises positioning a radiation shield opaque to the radiation from the plurality of radiation sources between at least a portion of the plate and at least a portion of the at least one back source, the radiation shield intervening between the irradiation field of the at least one front source and the at least one back source. The method further comprises irradiating the front side of the printing plate; and irradiating an area of the back side of the printing plate not covered by the radiation shield, such that no cross-sectionally aligned, opposing portions of the front side and back side of the plate are irradiated simultaneously.

The method may further include causing a first relative movement between the at least one front source and the plate in a movement direction orthogonal to the first dimension, and simultaneously causing a second relative movement between the radiation shield and the plate in the movement direction. In embodiment in which the radiation shield has a length extending beyond the irradiation field of the at least one front source in the movement direction, the method may further include adjusting the length of the radiation shield in the movement direction. The method may further including selectively reconfiguring the radiation shield between a first state in which the radiation shield blocks the radiation from the at least one back source and a second state in which the radiation shield does not block the radiation from the at least one back source. Specifically, the process may comprise selecting the first state when the relative movement is progressing from a first location to a second location in a scanning direction, and selecting the second state when the relative movement is progressing to the first location from the second location in a direction opposite the scanning direction. In one mode of operation, the second state may also be selected when the front exposure source is not activated, independent of direction of movement.

Still another aspect of the invention relates to an apparatus for preparing a printing plate comprising a photosensitive polymer activated by exposure to radiation. The apparatus comprises a plurality of radiation sources comprising at least one front source positioned to expose the front side of the plate to radiation and at least one back source positioned to expose the back side of the plate to radiation, the at least one front source having an irradiation field covering an area at least coextensive with a first dimension of the front side of the plate, the at least one back source comprising an array of sub-sources operable to produce an irradiation field covering an area coextensive with the back side of the plate. A holder is configured to receive the printing plate in a position to receive the radiation from the plurality of radiation sources. The apparatus includes means for causing relative movement between the at least one front source and the printing plate in a movement direction orthogonal to the first dimension; and a controller configured to operate the plurality of radiation sources to expose the plate to the radiation and to operate the means for causing relative movement. The controller is configured to operate the at least one front source to commence irradiating the front side of the plate, and to operate the array of sub-sources of the at least one back source to commence irradiating an area of the back side of the printing plate which does not overlap with the irradiation field of the at least one front source, such that no cross-sectionally aligned, opposing portions of front side and back side of the plate are irradiated simultaneously.

Still another aspect of the invention relates to an apparatus for preparing a printing plate comprising a photosensitive polymer activated by exposure to radiation. The apparatus comprises a plurality of radiation sources comprising at least one front source positioned to expose the front side of the plate to radiation and at least one back source positioned to expose the back side of the plate to radiation, the at least one front source having an irradiation field covering an area at least coextensive with a first dimension of the front side of the plate, the at least one back source having an irradiation field covering an area coextensive with the back side of the plate. A holder is configured to receive the printing plate in a position to receive the radiation from the plurality of radiation sources. The apparatus includes means for causing relative movement between the at least one front source and the printing plate received by the holder in a movement direction orthogonal to the first dimension. A controller configured to operate the plurality of radiation sources to expose the plate to the radiation, and to operate the means for causing relative movement. A surface surrounding each of the at least one back source of the plurality of radiation sources is opaque to the radiation from the plurality of radiation sources. The surface surrounding each of the at least one back source of the plurality of radiation sources is coated with a UV-absorbing coating.

Yet another aspect of the invention relates to a method for exposing a printing plate comprising a photosensitive polymer activated by exposure to radiation from a plurality of radiation sources. The plurality of radiation sources include at least one front source positioned to expose the front side of the plate to radiation and at least one back source positioned to expose the back side of the plate to radiation. The at least one front source has an irradiation field covering an area at least coextensive with a first dimension of the front side of the plate. The at least one back source comprises an array of sub-sources operable to produce an irradiation field covering an area coextensive with the back side of the plate. The method includes irradiating the front side of the printing plate with the at least one front source while creating relative movement between the at least one front source and the printing plate in a movement direction, and irradiating one or more areas of the back side of the printing plate that do not overlap with the irradiation field of the at least one front source, by activating and inactivating a variable set of sub-sources to produce a non-irradiated area synchronized with the relative movement of the at least one front source, such that no cross-sectionally aligned, opposing portions of front side and back side of the plate are irradiated simultaneously.

Still another aspect of the invention relates to a method for retrofitting an apparatus for preparing a printing plate comprising a photosensitive polymer activated by exposure to radiation, wherein the apparatus includes a plurality of radiation sources comprising at least one front source and at least one back source, the at least one front source having an irradiation field covering an area at least coextensive with a first dimension of the front side of the plate, and the at least one back source having an irradiation field covering an area coextensive with the back side of the plate. The apparatus further includes a holder configured to receive the printing plate in a position to receive the radiation from the plurality of radiation sources; means for causing relative movement between the at least one front source and the printing plate in a movement direction orthogonal to the first dimension; and a controller configured to operate the plurality of radiation sources to expose the plate to the radiation, and to operate the means for causing relative movement. The method for retrofitting comprises the step of configuring the apparatus to produce a non-irradiated area of the back side of the printing plate in the movement direction synchronized with the relative movement between the at least one front source and the printing plate in the movement direction such that no cross-sectionally aligned, opposing portions of the front side and back side of the plate receive irradiation simultaneously from the at least one front source and the at least one back source.

In embodiments in which the at least one back source comprises an array of sub-sources, the retrofitting step includes retrofitting the controller to synchronize the at least one back source to the relative motion of the at least one front source by activating and inactivating a variable set of sub-sources to produce the non-irradiated area synchronized with the relative movement of the at least one front source. In other embodiments, the retrofitting step includes (a) installing a radiation shield opaque to the radiation from the plurality of radiation sources, the radiation shield positioned between at least a portion of the printing plate and at least a portion of the at least one back source, (b) installing means for causing relative movement between the radiation shield and the printing plate. In some embodiments, the method may include installing a linkage between the means for causing relative movement between the radiation shield and the printing plate and the means for causing relative movement between the at least one front source as the printing plate. In other embodiments, the means for causing relative movement between the radiation shield and the printing plate may be independent of the means for causing relative movement between the at least one front source and the printing plate, in which case retrofitting includes configuring the controller to cause relative movement between the radiation shield and the printing plate in the movement direction synchronized with the relative movement between the at least one front source and the printing plate in the movement direction.

Still another aspect of the invention relates to a process for exposing a printing plate comprising a photosensitive polymer activated by exposure to radiation from a plurality of radiation sources. The plurality of radiation sources includes at least one front source positioned to expose the front side of the plate to radiation and at least one back source positioned to expose the back side of the plate to radiation. The at least one front source comprising an array of front sub-sources operable to produce an irradiation field covering an area coextensive with the front side of the plate. The at least one back source comprising an array of back sub-sources operable to produce an irradiation field covering an area coextensive with the back side of the plate. The method comprising the sequential steps of commencing irradiating the back side of the printing plate by activating at least a portion of the array of back sub-sources sufficient to cover the area coextensive with the back side of the plate in its entirety, then after a predefined delay, commencing irradiating the front side of the printing plate by activating fewer than all of the front sub-sources to apply radiation covering a collective area less than coextensive with the front side of the plate. The back sub-sources cross-sectionally aligned with activated front sub-sources are selectively inactivated to produce a non-irradiated area synchronized with the activated front sub-sources, such that no cross-sectionally aligned, opposing portions of front side and back side of the plate are irradiated simultaneously.

A related apparatus for preparing a printing plate according to the foregoing process includes the at least one front radiation source, the at least one back radiation source, the holder, and the controller, wherein the controller is configured to selectively operate the array of front sub-sources and the array of back sub-sources to perform the sequential steps of commencing irradiating the back side of the printing plate, commencing irradiating the front side of the printing plate after the predefined delay and selectively inactivating back sub-sources cross-sectionally aligned with activated front sub-sources to produce the non-irradiated area synchronized with the activated front sub-sources, such that no cross-sectionally aligned, opposing portions of front side and back side of the plate are irradiated simultaneously.

### BRIEF DESCRIPTION OF DRAWINGS

FIG. 1 is a schematic drawing depicting an example of an apparatus for the exposure of a photosensitive printing plate.
FIG. 2 is a schematic drawing depicting the apparatus of FIG. 1 with an alternative radiation shield.
FIG. 3A is a schematic drawing depicting an example of a radiation shield having an adjustable length in a first configuration.
FIG. 3B is a schematic drawing depicting the radiation shield of FIG. 3A in a second configuration longer than the first configuration.
FIG. 3C is a schematic drawing depicting an example of a radiation shield having an adjustable radiation blocking percentage in a maximum radiation blocking configuration.
FIG. 3D is a schematic drawing depicting the radiation shield of FIG. 3C in a minimum radiation blocking configuration.
FIG. 4 is a schematic drawing depicting an example of a drive mechanism and control system for an apparatus for the exposure of a photosensitive printing plate.
FIG. 5 is a schematic drawing depicting an example mechanical linkage for a drive mechanism for an apparatus for the exposure of a photosensitive printing plate.
FIG. 6 is a block diagram depicting an example process for exposing a photosensitive printing plate to radiation.
FIG. 7 is a schematic drawing depicting another example of an apparatus for the exposure of a photosensitive printing plate.
FIG. 8 is a schematic drawing depicting another example of an apparatus for the exposure of a photosensitive printing plate.
FIG. 9A is a schematic drawing depicting an example of a radiation shield having a variable blocking percentage in a maximum radiation blocking configuration.
FIG. 9B is a schematic drawing depicting the radiation shield of FIG. 9A in a minimum radiation blocking configuration.
FIG. 10 is a schematic drawing depicting another example of an apparatus for the exposure of a photosensitive printing plate

### DETAILED DESCRIPTION OF THE INVENTION

One potential avenue for avoiding the above-described back exposure problem involves applying back exposure significantly before or after front exposure. However, for the reasons below, those of skill in the art would understand that it is advantageous to have the back-exposure before front exposure, and to have only a small time delay between back and front exposure.

Oxygen is distributed throughout the photopolymer resin of a polymer plate at the time it is typically processed, and that oxygen is an inhibitor of the polymerization reaction commonly harnessed for curing the plates. Although polymerization caused by exposure of the polymer to actinic radiation scavenges this distributed oxygen, ambient oxygen will diffuse back into the resin over time if the plate is in contact with atmospheric air. Surprisingly, in processes in which a back exposure and main exposure are both performed on a plate, it has been found that fine detail on a plate may be optimized by imparting a defined delay between performing the back exposure and the main exposure. Without being held to any particular mechanism, it is believed that in this defined delay time following the back exposure, which scavenges oxygen from the back portion of the plate, oxygen from the front side of the plate starts to diffuse to the back side, thus creating a slightly less oxygen rich concentration in the area of the plate nearest the floor of the plate, such that the polymerization reactions near the floor of the plate react for longer before stopping and therefore create shapes on the plate that taper from the floor toward the top of the plate following the main exposure. It should be noted that a delay that is too long will reset the entire plate to being oxygen saturated, and a delay that is too short may not permit sufficient oxygen diffusion to produce optimal results. Thus, while the amount of the optimal delay may vary depending on any number of characteristics, it is important that the delay not be too long or too short, for optimal results. This delay may be imparted in any number of ways, described in more detail herein.

The apparatus and processes described herein may utilize a stationary radiation source for back-exposure and a moveable radiation source for front-exposure of the plate. The disclosed examples achieve the above-described delay in exposure through the use of a radiation shield located below the movable front radiation exposure source, between the back-exposure radiation source and a rear side of the polymer printing plate. The shading created by the shield may prevent interaction between back-exposure light and back reflected light from the front-exposure.

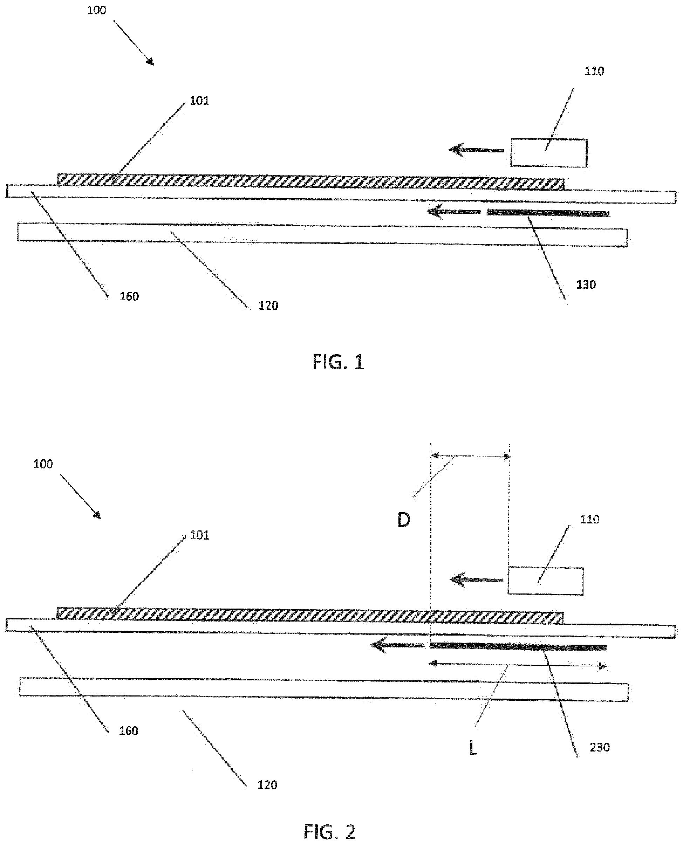

An example apparatus 100 for the exposure of photosensitive printing plate 101 is shown schematically in FIG. 1. Apparatus 100 includes a plurality of radiation sources 110 and 120, a radiation shield 130, and a holder 160. Additional details of apparatus 100 are set forth below.

As is well known in the art, printing plate 101 comprises a photosensitive polymer activated by exposure to radiation. Printing plate 101 has a non-printing back side and a printing front side with a mask for defining an image to be printed, i.e., by defining portions of the plate that are masked from radiation exposure relative to portions of the plate that are desired to receive such exposure.

Among the plurality of radiation sources, apparatus 100 includes at least one front radiation source 110 positioned to expose a front side of plate 101 to radiation, and at least one back radiation source 120 positioned to expose a back side of the plate to radiation. Radiation sources 110 and 120 have a predetermined power density and emit a predetermined type of radiation, e.g., ultraviolet (UV) radiation. Suitable UV radiation sources may comprise, for example and without limitation, LEDs, arrays of LEDs, fluorescent lights, such as fluorescent tubes, arc discharge lamps, or any other UV radiation source known in the art. Although primarily described herein in connection with a UV system and referring to "UV radiation", it should be understood that the technology described herein is not specific to any particular type of radiation wavelength, visible or non-visible, and that the system may utilize any type of actinic radiation or other radiation that is functional to cause the photochemical reaction necessary to cure the type of plate used.

The predetermined power for exposure form back radiation source 120 may be in a range between 20 mW/cm² up to 100 mW/cm². The predetermined power for exposure from front radiation source 110 may be in a range between 300 to 800 mW/cm². Such high intensity may be important in order to create flat top dots on conventional digital flexographic printing plates. Due to the high main exposure intensities and the high number of UV LED required for a full exposure of plate 101, main exposure sources be may designed as "linear" radiation sources, while back exposure sources may be designed as full-plate radiation sources, as described in greater detail below.

In one example, front radiation source 110 is a "one-dimensional" or "linear" radiation source, and has an irradiation field covering an area coextensive with a first dimension of the front side of plate 101. In other words, front radiation source 110 may have an irradiation field extending in a line along an entire width of plate 101 (wherein the "width" lies along the third dimension not shown in the 2-dimensional image of FIG. 1). In one example, back radiation source 120 is a "two-dimensional" radiation source, and has an irradiation field covering an area coextensive with first and second dimensions of the back side of plate 101. In other words, back radiation source 120 may have an irradiation field covering an entire area of the back side of plate 101. It will be understood that one or both of front radiation source 110 and back radiation source 120 may have other known shapes or designs, and may produce other known irradiation fields.

Any radiation source described herein may comprise a plurality of sub-sources (such as UV LED point sources) that together collectively create the described irradiation field. As discussed in U.S. Pat. No. 8,578,854, radiation sources may comprise a plurality of discrete units having a plurality of individual LED point sources on each unit, with the plurality of point sources arranged in a plurality of lines. All of the point sources on each unit may be controlled together, may be individually controlled, or may be controlled in groups. For example, each line of point sources in each radiation source may be separately controllable. As discussed in published PCT Application No. WO2020216948A1, assigned to the assignee of the present application and incorporated herein by reference in its entirety, the plurality of LEDs in the front or back radiation source may include multiple different species, each having a different center emission wavelength, arranged in an array of columns and rows.

Radiation shield 130 is opaque to the radiation from radiation sources 110 and 120. As used herein, the term "opaque" means that radiation shield 130 is neither transparent nor translucent to the radiation from radiation sources 110 and 120, and also that radiation shield 130 does not substantially reflect radiation from radiation sources 110 and 120. Radiation shield 130 preferably has strong absorbing properties for the radiation emitted by sources 110 and 120. In one example, radiation shield may be coated with a UV-absorbing coating, such as a paint containing, for example, titanium dioxide, zinc oxide or iron oxide nanoparticles.

Radiation shield 130 is positioned between at least a portion of plate 101 and at least a portion of back radiation source 120, in order to block radiation from back radiation source 120 from reaching plate 101. As shown in FIG. 1, radiation shield 130 may be spaced from both holder 160 and back radiation source 120. Alternatively, radiation shield 130 may be immediately adjacent or even in contact with holder 160 or back radiation source 120.

In addition to blocking radiation from back radiation source 120, radiation shield 130 prevents reflection of radiation from front radiation source 110 from reflecting off of back radiation source 120 and striking the back side of plate 101. To this end, radiation shield 130 is positioned to intervene between the irradiation field of front radiation source 110 and back radiation source 120.

Holder 160 is configured to support printing plate 101, in a position to receive radiation from radiation sources 110 and 120. It should be understood that the arrangement depicted in FIGS. 1 and 2 is schematic in nature only, to show an example of relative positioning of radiation sources 110 and 120 and radiation shield 130 relative to plate 101. In an apparatus 100 in which printing plate 101 is disposed along a horizontal plane, holder 160 may take the form of a transparent or at least partially transparent (to at least the actinic radiation) substrate (such as glass) on which plate 101 is disposed. In an apparatus 100 in which printing plate 101 is disposed along a vertical plane, holder 160 may take the form of a hanger, such that no substrate under the plate or other structure between the radiation source and the plate are required. Furthermore, although shown in a flat orientation, it should be understood that plate 101 may be flexible enough to be disposed around a transparent cylinder holder 160, such as a glass cylinder, or the plate may be in the form of a continuous sleeve, as is known in the art, with the distances between the light sources arranged relative to the rotational direction of the cylinder.

Apparatus 100 may further include means for causing relative movement between the components recited above. In particular, apparatus 100 may include means for causing relative movement between front radiation source 110 and holder 160, and means for causing relative movement between radiation shield 130 and holder 160. Front radiation source 110 and radiation shield 130 may be scanned along plate 101 in a scanning direction, .e.g., a direction orthogonal to the direction in which front radiation source 110 extends. In other words, when front radiation source 110 has an irradiation field extending in a line along an entire width of plate 101, front radiation source 110 and radiation shield 130 may be configured to move in an orthogonal direction, along a length of plate 101 (wherein the "length" lies along a horizontal direction of FIG. 1), such that front radiation source 110 scans an entire front surface of plate 101.

The relative movement between radiation sources/shield and plate 101 may be provided by any mechanism known in the art for moving objects relative to a horizontal, vertical, or otherwise disposed stationary surface. For configurations in which the radiation sources/shield move and plate 101 is stationary, for example, the sources may be disposed on a gantry or carriage system having arms that pass the respective components above and beneath a stationary horizontal plate mounted on a holder 160 being configured to permit a sufficient amount of radiation to pass through, or on either side of a vertically mounted plate. For configurations in which the radiation sources/shield are stationary and plate 101 is movable, for example, the plate may be mounted on any mechanism known in the art, such as a movable stage configured to move relative to fixed sources on opposite sides of the stage. Mechanisms for rotating a cylinder on which a plate is mounted relative to fixed sources are well known in the field of printing. Similarly, mechanisms for rotating sources/shield relative to a fixed cylinder on which a stationary object is mounted are also well known, such as in the field of medicine (e.g. CAT scan machines). Thus, mechanisms for moving one or more elements relative to another are well known in the art, generally, and the invention is not limited to any particular mechanism.

Apparatus 100 may further include a controller 140 configured to operate radiation sources 110 and 120 to expose plate 101 to radiation, and to operate the means for causing relative movement to move front radiation source 110 and/or radiation shield 130 relative to plate 101. In one example, controller 140 is configured to operate front radiation source 110 to commence irradiating the front side of plate 101, and operate back radiation source 120 to commence irradiating an area of the back side of plate 101 not covered by radiation shield 130. Due to the presence of the radiation shield intervening between the irradiation field of front radiation source 110 and back radiation source 120, there is no portion of plate 101 for which cross-sectionally aligned, opposing portions of the front side and back side are irradiated simultaneously. As used herein, the term "cross-sectionally aligned, opposing portions of the front side and back side" refer to areas of the plate that are directly across from one another and share a same X-Y coordinate on the plate separated only by the thickness of the plate in the Z direction across the cross-section of the plate. This "same X-Y coordinate" is referred to herein as a "cross-sectional coordinate," because the X-Y coordinate is constant across a cross-sectional line of the plate orthogonal to the front and back planes defined by the plate along the Z coordinates including and extending between the front and back surfaces of the plate along the plate thickness, all having a common X-Y coordinate. In other words, at no time is any specific cross-sectional coordinate on plate 101 being exposed from both the front side and the back side simultaneously, and thus apparatus 100 as a whole is configured to prevent simultaneous irradiation of any specific cross sectional coordinate on plate 101.

In a further example, controller 140 is configured to operate the means for causing relative movement to cause a first relative movement between front radiation source 110 and holder 160 in a scanning direction, and to simultaneously cause a second relative movement between radiation shield 130 and holder 160 in the same scanning direction.

Controller 140 may control movement of front radiation source 110 and the radiation shield to create a suitable delay between irradiation of regions of plate 101 with back radiation source 120 and irradiation of the same regions of plate 101 with front radiation source 110. In an example shown in FIG. 2, a radiation shield 230 has a length L extending in the scanning direction beyond the irradiation field of front radiation source 110. This length creates a space between a region of plate 101 irradiated by back radiation source 120 and a region of plate 101 irradiated by front radiation source 110. The length of radiation shield 230 can be selected to create a suitable distance in the scanning direction and, based on speed of movement of front radiation source 110 and radiation shield 230, provide a desired delay between irradiation of plate 101 by back radiation source 120 and irradiation of plate 101 by front radiation source 110. The time delay between back and front irradiation begins when movement of radiation shield 130 blocks irradiation of a region of plate 101 by back radiation source 120. The time delay ends when movement of front irradiation source 110 causes a start of irradiation of the region of plate 101 blocked by radiation shield 130. Although the example apparatus shown in FIG. 2 illustrates the time delay schematically in a linear system, it should be understood that various exposure systems may be devised to provide the optimized time delay.

The time delay between the back exposure with back radiation source 120 and the front exposure with front radiation source 110 may be adjusted by the controller 140 by adjusting the speed v of front radiation source 110 and the radiation shield, and/or mechanically adjusting a distance D between an edge of radiation shield 230 and the edge of the irradiation area of front radiation source 110 during the scan process. The time delay t = D / v. Thus, mechanically varying the distance D by adjusting a length of radiation shield 230 has an impact on the delay, as does the relative speed between plate 101, radiation source 110, and radiation shield 230 during exposure. The time delay can be optimized to get smaller single dot elements on the photosensitive printing plate after processing and smaller single element dot sizes printed on the print substrate, as described in U.S. Pat. No. 10,732,507, incorporated herein by reference.

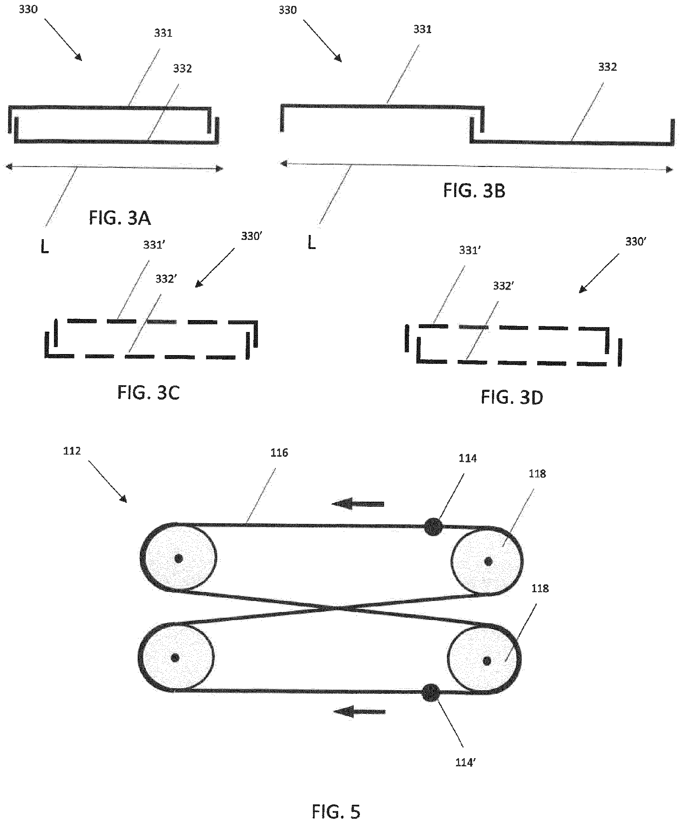

FIGS. 3A-3D depict examples of adjustable radiation shields for use in the disclosed apparatus for the exposure of a photosensitive printing plate. FIGS. 3A and 3B depict a radiation shield 330 having a first panel 331 and a second panel 332. Panels 331 and 332 are movably engaged with one another, e.g., in a sliding relationship, in order to adjust a length L of radiation shield 330 in a scanning direction. As shown in FIG. 3A, panels 331 and 332 are moved to maximize an overlap between panels 331 and 332, and thereby minimize a length L of radiation shield 330. As shown in FIG. 3B, panels 331 and 332 are moved to minimize an overlap between panels 331 and 332, and thereby maximize a length L of radiation shield 330.

FIGS. 3C and 3D depict another radiation shield 330' having a first perforated panel 331'and a second perforated panel 332', in which each perforation extends linearly across a portion of the dimension of the panel orthogonal to the movement direction, preferably across the full dimension of the panel overlying the plate in the first dimension. Perforated panels 331' and 332' are movably engaged with one another, e.g., in a sliding relationship, in order to adjust a length L of radiation shield 330' in a scanning direction. Perforated panels 331' and 332' are also movable to adjust alignment of perforations 334 in panels 331' and 332', so that radiation shield 330' is reconfigurable between a first state in which the radiation shield 330' blocks a first percentage (e.g. 100% or close thereto) of the radiation from a back radiation source (not shown), and a second state in which radiation shield 330' blocks a second percentage (less than the first percentage, and optimally as close to zero as possible) of radiation from back radiation source (not shown). As shown in FIG. 3C, panels 331' and 332' are in a configuration in which perforations 334 in panels 331' and 332' are not aligned with one another, and thereby at least one of the panels blocks radiation from passing through radiation shield 330'. As shown in FIG. 3D, panels 331' and 332' are in a configuration in which the perforations in panels 331' and 332' are aligned with one another, and thereby allow more radiation to pass through radiation shield 330' than in the configuration with non-aligned perforations, due to radiation passing through the aligned perforations.

The panels of shields 330 and 330' may include guides, tongue-and-groove connections, or other known connections that enable sliding. Radiation shield 330 and/or 330' may further include motors and/or other mechanical and/or electromechanical components for adjusting the relative position of their respective panels. The length L of radiation shield 330 or 330' may be adjusted manually or automatically by controller 140. Although depicted with two panels, it should be understood that in some embodiments, more than two panels may be provided.

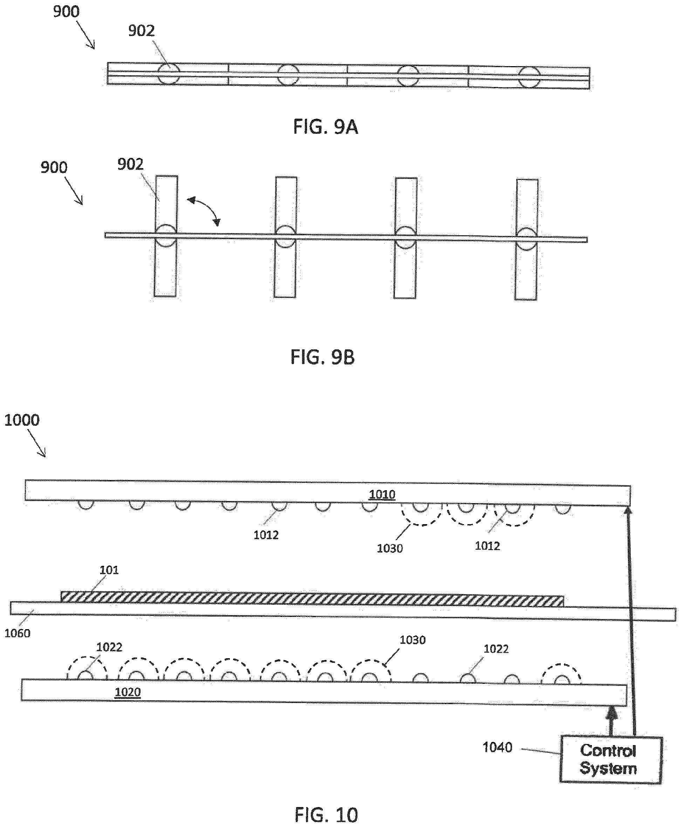

In an alternative example, depicted in FIGS. 9A and 9b, the radiation shield 900 may be configured like a louver or sun-blind with individual slats 902 that can be opened or closed to permit or block radiation from back radiation source 120. During scanning movement of the moveable front radiation source 110, the slats of the louver are closed (FIG. 9A) to prevent undesired floor growth due to back-reflected UV light. During a return movement back to a start position, the slats 902 of the louver are opened in order to allow nearly uninterrupted back exposure of plate 101. In the closed configuration with the slats in a horizontal position, essentially no radiation penetrates the shield (i.e. 100% radiation blocking), whereas in the open configuration some percentage of radiation blocking still occurs (corresponding to the percentage of the overall shield area covered by the slats in the vertical position). Such a configuration of the radiation shield may provide more homogenous curing results because the back exposure is only substantially interrupted during front exposure. Notably, the slats can be configured in any position between horizontal and vertical for percentage blocking between the minimum and the maximum. During some modes of operation, the shield may be disposed in the minimally blocking position whenever the front source is off. During a back-only exposure step, the shield may be positioned relative to the plate so that no portion of the shield is disposed between the back sources and the plate. In another embodiment, such as, for example, if space and/or linkages with the front source do not facilitate such a non-blocking position during a back-only exposure step, the shield may be disposed in the minimally blocking state with relative movement initiated between the shield and the plate to ensure that the blocking portions of the shield even in the minimally blocking position do not cast their shadow over any one portion of the back of the plate more than any other portion.

The invention is not limited to any particular mechanism or means for providing a shield configured to switch between a first, relatively greater percentage of radiation blocking and a second, relatively lesser percentage of radiation blocking.

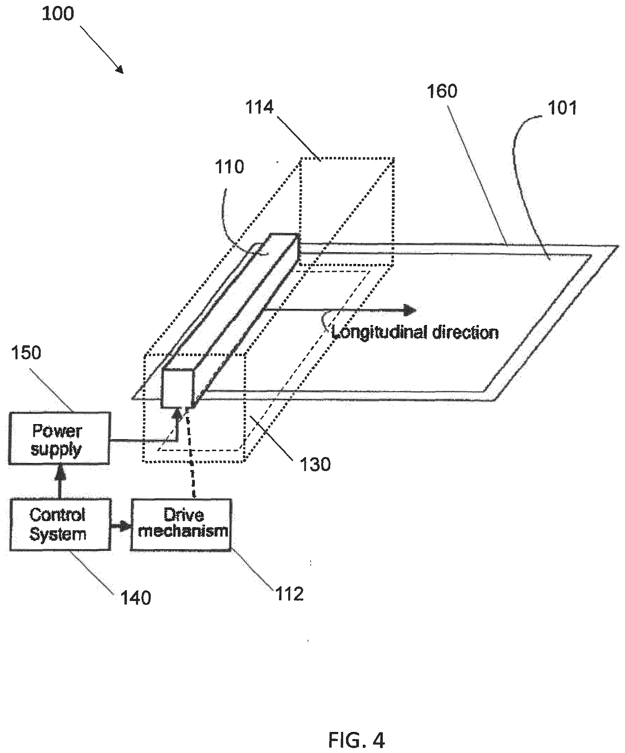

FIG. 4 depicts an example of the means for causing relative movement of front radiation source 110 and plate 101. While not illustrated in FIG. 4, it will be understood that any of the radiation shields disclosed herein can be moved in substantially the same fashion as depicted and described for front radiation source 110. In FIG. 4, front radiation source 110 is configured to be scanned at a specific speed in a longitudinal direction over the top of plate 101. Likewise, radiation shield 130 can be configured to be scanned at the same speed underneath the bottom of plate 101.

Drive mechanism 112 may include any components known in the art for creating relative movement of components including, for example, one or more driving motors. Drive mechanism 112 further includes a carriage 114 that holds front radiation source 110 in such a manner that source 110 irradiates the top surface of plate 101 as front radiation source 110 is scanned across the plate 101. Carriage 114 traverses plate 101 in the longitudinal (or lateral) direction shown by arrow in FIG. 4. Holder 160 holds plate 101 thereon, without obstruction between plate 101 and front radiation source 110. While the exposure step may be performed in a single pass, in some embodiments the exposure may be performed in a plurality of passes, in which each pass imparts radiation. As will be understood, carriage 114 may have a first speed when traversing the plate along the longitudinal direction with radiation sources activated, and a second, faster speed when traversing the plate in the opposite direction, to reset for another pass or at the completion of the desired number of passes.

As set forth above, it may be desirable to synchronize movement of front radiation source 110 and radiation shield 130 using controller 140, such that these components are driven to move simultaneously at the same speed with one or more drive motors. In some embodiments, the drivers for the radiation source and the radiation shield may be independent of one another, with synchronization provided solely by the controller. In other embodiments, the synchronous movement may be achieved by attaching both components to a common carriage that traverses plate 101, so that radiation shield 130 is contained to move with front radiation source 110 during scanning. In still other embodiments, the drivers for the radiation source and the radiation shield may be linked to one another.

In the example shown in FIG. 5, drive mechanism 112 may include one or more linkages 116 between a carriage 114 which conveys front radiation source 110 above plate 101 and a corresponding carriage 114' which conveys radiation shield 130 beneath plate 101. The linkage 116 of drive mechanism 112 may include, for example, one or more components selected from the group consisting of Bowden cables, magnetic elements, belts, or chains. A mechanical linkage 116 may include one or more pulleys, wheels, drums, pulleys, or other components (generally designated by 118) to connect the motion of carriage 114 with carriage 114'. Other suitable linkages for synchronizing movement of front radiation source 110 and radiation shield 130 will be known.

In another embodiment, magnetic or electromagnetic elements on the carriage (not shown) may be magnetically coupled to mating magnetic elements on the shield (not shown), such that the motive force of the carriage 114 is transferred to the shield through the glass plate by the magnetic coupling forces.

Radiation sources 110 and 120 are connected to a power supply 150. To enable relative motion of front radiation source 110, power supply 150 may include as an electrical power cord having sufficient slack to extend the full range of motion of carriage 114. Tracks (not shown) provide a defined path for the gantry system or carriage 114 to traverse. Carriage 114 may be moved on the tracks by any drive mechanism 112 known in the art, including a chain drive, a spindle drive, gear drive, or the like. As shown in FIG. 4, drive mechanism 112 is coupled to controller 140 and power supply 150 to effect control and movement of front radiation source 110. Drive mechanism 112 for carriage 114 may comprise one or more components mounted within the carriage, one or more components fixed to holder 160, or a combination thereof. A position sensor (not shown) is preferably coupled to carriage 114 to provide feedback to controller 140 regarding the precise location of carriage 114 at any given time.

A control signal output from controller 140 for operating radiation sources 110 and 120 and for controlling motion of front radiation source 110 and/or radiation shield 130 may be supplied via a wired or wireless connection. Controller 140 may be mounted in a fixed location, such as connected to holder 160 with a control signal cable attached to radiation source 110 similar to the power cable, or may be mounted in or on carriage 114. Controller 140 and drive mechanism 112 cooperate to cause back/forth relative motion in a transverse direction between front radiation source 110, radiation shield 130, and plate 101. If should be understood that other embodiments may be devised in which the drive mechanism is configured to move the portion of holder 160 supporting plate 101 past stationary upper and lower linear radiation sources, as well as embodiments in which the radiation sources cover less than the full width of the plate and are movable in both the transverse and longitudinal direction to provide total plate coverage (or the plate is movable in both directions, or the plate is movable in one of the two directions and the sources are movable in the other direction to provides the full range of motion required to cover the entire plate).

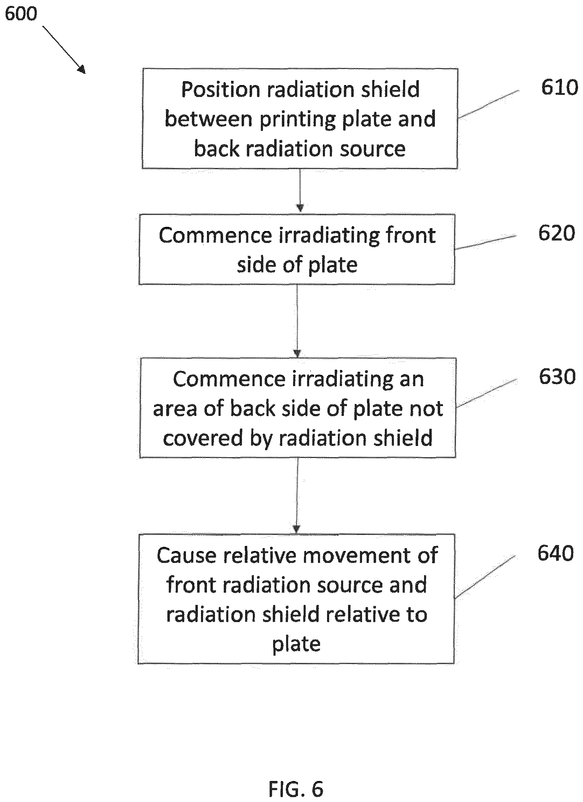

An example process 600 for the exposure of photosensitive printing plate 101 is shown diagrammatically in FIG. 6. Process 600 includes positioning a radiation shield, commencing irradiation of front and back sides of plate 101. It should be understood that process 600 is not limited to any particular physical embodiment, and may be performed in any system having any physical configuration. Nonetheless, additional details of process 600 are set forth below and described with respect to the components of apparatus 100.

In step 610, a radiation shield is positioned between at least a portion of a printing plate and at least a portion of a back radiation source. In an example, radiation shield 130 is positioned between a portion of plate 101 and a portion of back radiation source 120. Radiation shield 130 is positioned such that it intervenes between an irradiation field of front radiation source 110 and back radiation source 120. As set forth above, radiation shield 130 is opaque to radiation from front and back radiation sources 110 and 120, and may be formed, for example, from UV-absorbing paint.

In step 620, irradiation is commenced for the front side of the printing plate. In an example, front radiation source 110 commences irradiating a portion of the front side of plate 101. As set forth above, front radiation source 110 may be a "linear" source that irradiates an area coextensive with a width of plate 101.

In step 630, irradiation is commenced for the back side of the printing plate. In an example, back radiation source 120 commences irradiating an area of the back side of printing plate 101 which is not covered by radiation shield 130. Due to positioning of radiation shield 630, there is no portion of plate 101 for which the front side and back side are irradiated simultaneously. It will be understood that the irradiation performed in steps 620 and 630 may be performed in any order, and may be performed simultaneously, in particular, during scanning of the front radiation source and radiation shield, as described below.

Process 600 may include a further step, step 640, of causing relative movement of the front radiation source and the radiation shield relative to the printing plate. In an example, drive mechanism 112 causes relative movement of front radiation source 110 and radiation shield 130 in a scanning direction (orthogonal to the width of plate 101) relative to plate 101. As set forth above, radiation shield 230 may have a length L extending in the scanning direction beyond the irradiation field of front radiation source 110. Thus, the step of causing relative movement of radiation source 110 and radiation shield 130 can result in the creation of a desired time delay between exposure of a region of plate 101 by back radiation source 120 and exposure of the same region of plate 101 by front radiation source 110.

As set forth above, radiation shield 330 may have a length L extending in the scanning direction beyond the irradiation field of front radiation source 110. The length of radiation shield 330 can be adjusted to provide a desired delay between irradiation of plate 101 by back radiation source 120 and irradiation of plate 101 by front radiation source 110. In this example, process 600 may include a step of adjusting the length of the radiation shield in the movement direction, in order to adjust a length of a delay between irradiation by back radiation source 120 and irradiation by front radiation source 110 during movement of front radiation source 110 and radiation shield 330.

As set forth above, radiation shield 330' may have perforations 334 to allow radiation therethrough in certain configurations. In this example, process 600 may include reconfiguring radiation shield 330' between a first state in which the radiation shield 330' blocks radiation from back radiation source 120 and a second state in which radiation shield 330' does not block the radiation from back radiation source 120.

In one example, the exposure of the printing plate may be carried out using a multitude of consecutive exposure steps, in which each step contributes a fraction of the total energy dose required for complete curing of the plate, as is known in the art. As such, the steps of process 600 may be repeated as needed until the plate has been exposed to the total amount of radiation desired.

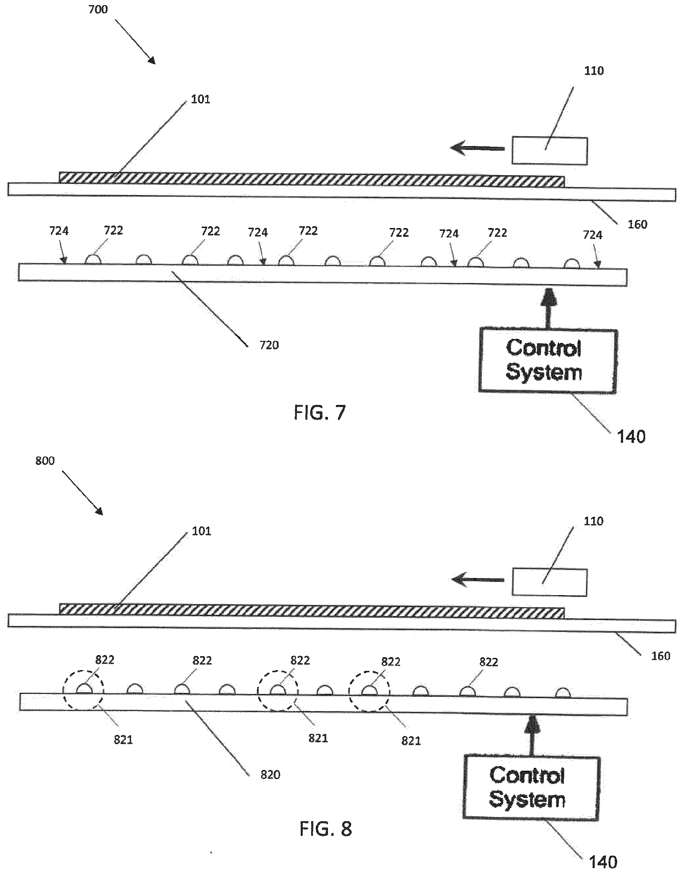

Another example apparatus 700 for the exposure of photosensitive printing plate 101 is shown schematically in FIG. 7. Apparatus 700 includes a plurality of radiation sources 110 and 720, and a holder 160. Apparatus 700 may include any of the features and perform any of the functions set forth above with respect to apparatus 100. Additional details of apparatus 700 are set forth below.

Among the plurality of radiation sources, apparatus 100 includes at least one front radiation source 110 positioned to expose a front side of plate 101 to radiation, and at least one back radiation source 720 positioned to expose a back side of the plate to radiation. In one example, back radiation source 720 is a "two-dimensional" radiation source, and has an irradiation field covering an area coextensive with first and second dimensions of the back side of plate 101, as described above with respect to back radiation source 120.

Back radiation source 720 comprises a plurality of sub-sources 722 (such as UV LED point sources) that together collectively create the described irradiation field. Back radiation source 720 further comprises at least one surface 724 surrounding each of the sub-sources 722. Surface 724 faces plate 101 and front radiation source 110, and may form part of a housing or mounting of back radiating source 720.

Surface 724 is opaque to the radiation from front radiation source 110 and back radiation source 720. As a result, surface 724 minimizes back-reflection of radiation from front radiation source 110 reflecting off of back radiation source 720 and irradiating the back surface of plate 101.

In one example, surface 724 is coated with a UV-absorbing coating, such as a UV-absorbing paint. In another example, surface 724 may be coated with one or more anti-reflective layers. Suitable materials or coatings for use in minimizing reflection of radiation from front radiation source 110 will be known.

Yet another example apparatus 800 for the exposure of photosensitive printing plate 101 is shown schematically in FIG. 8. Apparatus 800 includes a plurality of radiation sources 110 and 820, controller 140, and a holder 160. Apparatus 800 may include any of the features and perform any of the functions set forth above with respect to apparatus 100 and 700. Additional details of apparatus 800 are set forth below.

Among the plurality of radiation sources, apparatus 800 includes at least one front radiation source 110 positioned to expose a front side of plate 101 to radiation, and at least one back radiation source 820 positioned to expose a back side of the plate to radiation. In one example, front radiation source 110 is a "one-dimensional" or "linear" radiation source, and has an irradiation field covering an area coextensive with a first dimension of the front side of plate 101. In one example, back radiation source 820 is a "two-dimensional" radiation source, and has an irradiation field covering an area coextensive with first and second dimensions of the back side of plate 101, as described above with respect to back radiation source 120.

Back radiation source 820 comprises a plurality of sub-sources or point sources 822 (such as UV LED point sources) that together collectively create the described irradiation field. Radiation sub-sources are arranged in a plurality of discrete units 821 having a plurality of sub-sources (e.g., individual LED point sources) on each unit 821. The plurality of subs-sources 822 in each unit are arranged in a plurality of lines extending in the same direction as front radiation source 110, i.e., a plurality of lines extending along the first dimension of plate 101 (in other words, along the width of plate 101 and into the page in FIG. 8).

All of the point sources 822 on each unit 821 may be controlled together by controller 140, may be individually controlled by controller 140, or may be controlled in groups. For one example, each line of point sources 822 comprising each unit 821 is separately controllable by controller 140.

In one example of operation of apparatus 800, controller 140 is configured to operate front radiation source 110 to commence irradiating the front side of plate 101, and operate back radiation source 820 to commence irradiating an area of the back side of plate 101 that does not overlap with the irradiation field of front radiation source 110. In particular, by only commencing irradiation with units 821 of back radiation source 820 that do not irradiate the same portion of plate 101 as front irradiation source 110, there is no portion of plate 101 for which the front side and back side are irradiated simultaneously. In other words, at no time is any specific cross-sectional coordinate on plate 101 being exposed from both the front side and the back side simultaneously, and thus apparatus 800 as a whole is configured to prevent simultaneous irradiation of any specific cross sectional coordinate on plate 101.

In a further example, controller 140 is configured to operate the means for causing relative movement to cause a first relative movement between front radiation source 110 and holder 160 in a scanning direction. In this example, controller 140 may be configured to sequentially turn off and on units 821 of back radiation source 820, in order to accommodate the motion of front radiation source 110, and maintain the condition that back radiation source 820 irradiates an area of the back side of plate 101 that does not overlap with the irradiation field of front radiation source 110 as front radiation source 110 is scanned along plate 101. Such a configuration essentially creates a virtual radiation shield within the back exposure irradiation field. By contrast to the configuration of a "virtual" linear source as described with respect to embodiments in U.S. 10,732,507, rather than having a virtual linear back irradiation source formed with an area back irradiation source by cause a moving subset of "on" sub-sources within a field of "off" sub-sources to lead a physical or virtual front linear source with a designated delay, here the individual sources that form the area back radiation source are all "on," except for an area of "off" sources that define a non-irradiated area that moves directly under and synchronized with the front source. Through the above-described operation, controller 140 is configured to create a desired time delay without the need for a physical structure such as a radiation shield, but rather by pulsing discrete units 821 of back radiation source 820 relative to plate 101. As shown in FIG. 8, back radiation source 820 (including one or more sub-sources) spatially overlaps with front radiation source 110, but the controller is configured so that such overlapping sources never actively irradiate the plate at the same time, even during relative movement of front radiation source 110 and plate 101.

While the front radiation source is described above primarily in the context of systems comprising a linear radiation source on a carriage that physically traverses the region above the front side of the plate, and a stationary area back source, it should be understood that the invention may also be implemented using a system such as system 1000 depicted in FIG. 10. In system 1000, an area front radiation source 1010 is controlled by controller 1040 to create a virtual linear traversal of "on" sub-sources 1012 of the area front radiation source that is mirrored by a virtual linear traversal of "off" sources 1022 of the area back source 1020. As depicted, a dashed semicircle 1030 surrounding each sub-source indicates irradiation is emanating from the corresponding source, meaning the source is "on," and the absence of such a semicircle indicates the source is "off." It should further be understood that in such a virtual system, the "on" sub-sources of the front area source and the "off" sub-sources of the back area source may be aligned in any pattern, not limited to linear patterns. A key difference from the embodiments described in U.S. 10,732,507 is that rather than sub-sources being pulsed "on" on the back side followed by sub-sources being pulsed "on" on the front side after a delay, the back sub-sources may at least in a portion corresponding to the area of the back of the plate all be "on" throughout the front exposure, except in the non-irradiated area(s) formed by "off" sub-sources directly below and synchronized with the "on" front sub-sources. The application of radiation from the back sub-sources applied in the manner as described herein may be at a lesser intensity for a greater amount of time, than if pulsed on for a shorter amount of time, and such lesser intensity sources may be less expensive or may have other advantages relative to prior art systems that require shorter, more intense bursts from the back side.

Notably, the systems as described herein may be particularly well suited for retrofitting existing systems having a linear front radiation source and full-plate back radiation source to provide the improvements in performance as detailed herei n.

Although the invention is illustrated and described herein with reference to specific embodiments, the invention is not intended to be limited to the details shown. Rather, various modifications may be made in the details within the scope and range of equivalents of the claims and without departing from the invention.

While preferred embodiments of the invention have been shown and described herein, it will be understood that such embodiments are provided by way of example only. Numerous variations, changes and substitutions will occur to those skilled in the art without departing from the spirit of the invention. Accordingly, it is intended that the appended claims cover all such variations as fall within the spirit and scope of the invention.

In the following, further features, characteristics and advantages of the invention will be described by means of items:
Item 1. An apparatus for preparing a printing plate comprising a photosensitive polymer activated by exposure to radiation, the printing plate having a non-printing back side and a printing front side with a mask for defining an image to be printed, the apparatus comprising:
   a. a plurality of radiation sources comprising at least one front source positioned to expose the front side of the plate to radiation and at least one back source positioned to expose the back side of the plate to radiation, the at least one front source having an irradiation field covering an area at least coextensive with a first dimension of the front side of the plate, the at least one back source having an irradiation field covering an area coextensive with the back side of the plate;
   b. a holder configured to receive the printing plate in a position to receive the radiation from the plurality of radiation sources;
   c. means for causing relative movement (i) between the at least one front source and the printing plate in a movement direction orthogonal to the first dimension and (ii) between the printing plate and a non-irradiated area of the back side of the printing plate in the movement direction within an otherwise irradiated area coextensive with the back side of the printing plate; and
   d. a controller configured to operate the plurality of radiation sources to expose the plate to the radiation, and to operate the means for causing relative movement, such that no cross-sectionally aligned, opposing portions of the front side and back side of the plate receive irradiation simultaneously from the at least one front source and the at least one back source.
Item 2. The apparatus of item 1, wherein the at least one back source comprises an array of sub-sources, and the controller is configured to operate the at least one front source to irradiate the front side of the plate along the movement direction, and to activate and inactivate a variable set of the sub-sources of the at least one back source synchronized with the relative motion of the at least one front source to cause irradiation of the back side of the printing plate except for in the non-irradiated area, wherein at least a portion of the non-irradiated area is cross-sectionally aligned with the opposing portion of the front side of the plate simultaneously irradiated by the at least one front source.
Item 3. The apparatus of item 1 or 2, further comprising:
   a radiation shield opaque to the radiation from the plurality of radiation sources, the radiation shield positioned between at least a portion of the printing plate and at least a portion of the at least one back source, and
   means for causing relative movement between the radiation shield and the printing plate;
   wherein the controller is further configured to cause a first relative movement between the at least one front source and the printing plate in the movement direction, and to simultaneously cause a second relative movement between the radiation shield and the printing plate in the movement direction.
Item 4. The apparatus of item 3, wherein the radiation shield has a length extending in the movement direction beyond the irradiation field of the at least one front source.
Item 5. The apparatus of item 4, wherein the length of the radiation shield is adjustable in the movement direction.
Item 6. The apparatus of any one of items 3-5, wherein the radiation shield is reconfigurable between a first state in which the radiation shield blocks a first percentage of the radiation from the at least one back source and a second state in which the radiation shield blocks a second percentage of the radiation from the at least one back source, wherein the first percentage is greater than that the second percentage.
Item 7. The apparatus of item 6, wherein the first percentage is a maximum percentage and the second percentage is a minimum percentage.
Item 8. The apparatus of items 6 or 7, wherein the radiation shield comprises a plurality of louvers movable between a first configuration in which each louver blocks a maximum percentage of radiation between the at least one back source and the printing plate, and second configuration in which each louver blocks a minimum percentage of radiation between the at least one back source and the printing plate.
Item 9. The apparatus of any one of items 3 to 8, wherein the radiation shield comprises two panels serially disposed between the at least one back source and the back side of the printing plate, the two panels defining an overlapping region in which respective portions of both panels are disposed between the at least one back source and the back side of the printing plate and at least one non-overlapping region in which only one of the two panels is disposed between the least one back source and the back side of the printing plate, at least one panel being laterally adjustable relative to the other panel to adjust an overall effective length of the radiation shield in which at least one panel is disposed between the at least one back source and the back side of the printing plate.
Item 10. The apparatus of any one of items 3 to 8, wherein the radiation shield comprises at least two panels serially disposed between the at least one back source and the back side of the printing plate, the at least two panels defining an overlapping region in which respective portions of the panels are disposed between the at least one back source and the back side of the printing plate, each of the at least two panels having one or more linear perforations extending across at least a portion of the first dimension, at least one of the at least two panels being laterally adjustable between the first state in which respective perforations of the panels are aligned and the second state in which the respective perforations of the patents are not aligned.
Item 11. The apparatus of any one of items 3-10, wherein the means for causing relative movement includes a first means for causing relative movement between the at least one front radiation source and the printing plate and a second means for causing relative movement between the radiation shield and the printing plate.
Item 12. The apparatus of item 11, wherein the means for causing relative movement comprises at least one driving motor, and further comprises one or more components linking the first means and the second means selected from the group consisting of Bowden cables, magnetic elements, belts, or chains.
Item 13. The apparatus of item 11 or 12, wherein the first means and the second means are independent from one another, and the controller is configured to synchronize the first means and the second means.
Item 14. The apparatus of any one of items 1-13, wherein the one or more radiation sources comprise a plurality of LED point sources configured to emit UV light.
Item 15. The apparatus of any one of items 1-14, wherein the radiation shield comprises a UV-absorbing coating.
Item 16. The apparatus of any one of items 1-15, wherein the holder comprises a substrate on which the plate is disposed, wherein the substrate is at least partially transparent to the radiation.
Item 17. A process for exposing a printing plate comprising a photosensitive polymer activated by exposure to radiation from a plurality of radiation sources, the printing plate having a non-printing back side and a printing front side with a mask for defining an image to be printed, the plurality of radiation sources including at least one front source positioned to expose the front side of the plate to radiation and at least one back source positioned to expose the back side of the plate to radiation, the at least one front source having an irradiation field covering an area at least coextensive with a first dimension of the front side of the plate, the at least one back source having an irradiation field covering an area coextensive with the back side of the plate, the method comprising:
   a. positioning a radiation shield opaque to the radiation from the plurality of radiation sources between at least a portion of the plate and at least a portion of the at least one back source, the radiation shield intervening between the irradiation field of the at least one front source and the at least one back source
   b. irradiating the front side of the printing plate; and
   c. irradiating an area of the back side of the printing plate not covered by the radiation shield, such that no cross-sectionally aligned, opposing portions of the front side and back side of the plate are irradiated simultaneously.
Item 18. The process of item 17, wherein the method further comprises causing a first relative movement between the at least one front source and the plate in a movement direction orthogonal to the first dimension, and simultaneously causing a second relative movement between the radiation shield and the plate in the movement direction
Item 19. The process of item 18, wherein the radiation shield has a length extending beyond the irradiation field of the at least one front source in the movement direction, and further comprising adjusting the length of the radiation shield in the movement direction.
Item 20. The process of any one of items 17-19, further comprising selectively reconfiguring the radiation shield between a first state in which the radiation shield blocks the radiation from the at least one back source and a second state in which the radiation shield does not block the radiation from the at least one back source.
Item 21. The process of items 20, comprising selecting the first state when the relative movement is progressing from a first location to a second location in a scanning direction, and selecting the second state when the relative movement is progressing to the first location from the second location in a direction opposite the scanning direction.
Item 22. An apparatus for preparing a printing plate comprising a photosensitive polymer activated by exposure to radiation, the printing plate having a non-printing back side and a printing front side with a mask for defining an image to be printed, the apparatus comprising:
   a plurality of radiation sources comprising at least one front source positioned to expose the front side of the plate to radiation and at least one back source positioned to expose the back side of the plate to radiation, the at least one front source having an irradiation field covering an area at least coextensive with a first dimension of the front side of the plate, the at least one back source comprising an array of sub-sources operable to produce an irradiation field covering an area coextensive with the back side of the plate;
   a holder configured to receive the printing plate in a position to receive the radiation from the plurality of radiation sources;
   means for causing relative movement between the at least one front source and the printing plate in a movement direction orthogonal to the first dimension; and
   a controller configured to operate the plurality of radiation sources to expose the plate to the radiation, and to operate the means for causing relative movement,
   wherein the controller is configured to operate the at least one front source to commence irradiating the front side of the plate, and operate the array of sub-sources of the at least one back source to commence irradiating an area of the back side of the printing plate which does not overlap with the irradiation field of the at least one front source, such that no cross-sectionally aligned, opposing portions of front side and back side of the plate are irradiated simultaneously.
Item 23. An apparatus for preparing a printing plate comprising a photosensitive polymer activated by exposure to radiation, the printing plate having a non-printing back side and a printing front side with a mask for defining an image to be printed, the apparatus comprising:
   a plurality of radiation sources comprising at least one front source positioned to expose the front side of the plate to radiation and at least one back source positioned to expose the back side of the plate to radiation, the at least one front source having an irradiation field covering an area at least coextensive with a first dimension of the front side of the plate, the at least one back source having an irradiation field covering an area coextensive with the back side of the plate;
   a holder configured to receive the printing plate in a position to receive the radiation from the plurality of radiation sources;
   means for causing relative movement between the at least one front source and the printing plate received by the holder in a movement direction orthogonal to the first dimension; and
   a controller configured to operate the plurality of radiation sources to expose the plate to the radiation, and to operate the means for causing relative movement,
   wherein a surface surrounding each of the at least one back source of the plurality of radiation sources is opaque to the radiation from the plurality of radiation sources.
Item 24. The apparatus of item 23, wherein the surface surrounding each of the at least one back source of the plurality of radiation sources is coated with a UV-absorbing coating.
Item 25. A process for exposing a printing plate comprising a photosensitive polymer activated by exposure to radiation from a plurality of radiation sources, the printing plate having a non-printing back side and a printing front side with a mask for defining an image to be printed, the plurality of radiation sources including at least one front source positioned to expose the front side of the plate to radiation and at least one back source positioned to expose the back side of the plate to radiation, the at least one front source having an irradiation field covering an area at least coextensive with a first dimension of the front side of the plate, the at least one back source comprising an array of sub-sources operable to produce an irradiation field covering an area coextensive with the back side of the plate, the method comprising:
   a. commencing irradiating the front side of the printing plate with the at least one front source while creating relative movement between the at least one front source and the printing plate in a movement direction; and
   b. commencing irradiating one or more areas of the back side of the printing plate that do not overlap with the irradiation field of the at least one front source, by activating and inactivating a variable set of sub-sources to produce a non-irradiated area synchronized with the relative movement of the at least one front source, such that no cross-sectionally aligned, opposing portions of front side and back side of the plate are irradiated simultaneously.
Item 26. A method for retrofitting an apparatus for preparing a printing plate comprising a photosensitive polymer activated by exposure to radiation, the printing plate having a non-printing back side and a printing front side with a mask for defining an image to be printed, the apparatus comprising:
   a plurality of radiation sources comprising at least one front source positioned to expose the front side of the plate to radiation and at least one back source positioned to expose the back side of the plate to radiation, the at least one front source having an irradiation field covering an area at least coextensive with a first dimension of the front side of the plate, the at least one back source having an irradiation field covering an area coextensive with the back side of the plate;
   a holder configured to receive the printing plate in a position to receive the radiation from the plurality of radiation sources;
   means for causing relative movement between the at least one front source and the printing plate in a movement direction orthogonal to the first dimension; and
   a controller configured to operate the plurality of radiation sources to expose the plate to the radiation, and to operate the means for causing relative movement,
   wherein the method for retrofitting comprises the step of configuring the apparatus to produce a non-irradiated area of the back side of the printing plate in the movement direction synchronized with the relative movement between the at least one front source and the printing plate in the movement direction such that no cross-sectionally aligned, opposing portions of the front side and back side of the plate receive irradiation simultaneously from the at least one front source and the at least one back source.
Item 27. The method of item 26, wherein the at least one back source comprises an array of sub-sources, and the retrofitting step includes retrofitting the controller to synchronize the at least one back source to the relative motion of the at least one front source by activating and inactivating a variable set of sub-sources to produce the non-irradiated area synchronized with the relative movement of the at least one front source.
Item 28. The method of item 26 or 27, wherein the retrofitting step includes (a) installing a radiation shield opaque to the radiation from the plurality of radiation sources, the radiation shield positioned between at least a portion of the printing plate and at least a portion of the at least one back source, (b) installing means for causing relative movement between the radiation shield and the printing plate.
Item 29. The method of item 28, comprising installing a linkage between the means for causing relative movement between the radiation shield and the printing plate and the means for causing relative movement between the at least one front source as the printing plate.
Item 30. The method of item 28 or 29, wherein the means for causing relative movement between the radiation shield and the printing plate is independent of the means for causing relative movement between the at least one front source as the printing plate, further comprising configuring the controller to cause relative movement between the radiation shield and the printing plate in the movement direction synchronized with the relative movement between the at least one front source and the printing plate in the movement direction.
Item 31. A process for exposing a printing plate comprising a photosensitive polymer activated by exposure to radiation from a plurality of radiation sources, the printing plate having a non-printing back side and a printing front side with a mask for defining an image to be printed, the plurality of radiation sources including at least one front source positioned to expose the front side of the plate to radiation and at least one back source positioned to expose the back side of the plate to radiation, the at least one front source comprising an array of front sub-sources operable to produce an irradiation field covering an area coextensive with the front side of the plate, the at least one back source comprising an array of back sub-sources operable to produce an irradiation field covering an area coextensive with the back side of the plate, the method comprising the sequential steps of:
   a. commencing irradiating the back side of the printing plate by activating at least a portion of the array of back sub-sources sufficient to cover the area coextensive with the back side of the plate in its entirety;
   b. after a predefined delay, commencing irradiating the front side of the printing plate by activating fewer than all of the front sub-sources to apply radiation covering a collective area less than coextensive with the front side of the plate; and
   c. selectively inactivating back sub-sources cross-sectionally aligned with activated front sub-sources to produce a non-irradiated area synchronized with the activated front sub-sources, such that no cross-sectionally aligned, opposing portions of front side and back side of the plate are irradiated simultaneously.
Item 32. An apparatus for preparing a printing plate comprising a photosensitive polymer activated by exposure to radiation, the printing plate having a non-printing back side and a printing front side with a mask for defining an image to be printed, the apparatus comprising:
   at least one front radiation source positioned to expose the front side of the plate to radiation and comprising an array of front sub-sources operable to produce an irradiation field covering an area coextensive with the front side of the plate;
   at least one back radiation source positioned to expose the back side of the plate to radiation and comprising an array of back sub-sources operable to produce an irradiation field covering an area coextensive with the back side of the plate;
   a holder configured to receive the printing plate in a position to receive the radiation from the at least one front radiation source and the at least one back radiation source;
   a controller configured to selectively operate the array of front sub-sources and the array of back sub-sources to perform the sequential steps of:
      a. commencing irradiating the back side of the printing plate by activating at least a portion of the array of back sub-sources sufficient to cover the area coextensive with the back side of the plate in its entirety;
      b. after a predefined delay, commencing irradiating the front side of the printing plate by activating fewer than all of the front sub-sources to apply radiation covering a collective area less than coextensive with the front side of the plate; and
      c. selectively inactivating back sub-sources cross-sectionally aligned with activated front sub-sources to produce a non-irradiated area synchronized with the activated front sub-sources, such that no cross-sectionally aligned, opposing portions of front side and back side of the plate are irradiated simultaneously.

## Claims

1. An apparatus for preparing a printing plate comprising a photosensitive polymer activated by exposure to radiation, the printing plate having a non-printing back side and a printing front side with a mask for defining an image to be printed, the apparatus comprising:
a. a plurality of radiation sources comprising at least one front source positioned to expose the front side of the plate to radiation and at least one back source positioned to expose the back side of the plate to radiation, the at least one front source having an irradiation field covering an area at least coextensive with a first dimension of the front side of the plate, the at least one back source having an irradiation field covering an area coextensive with the back side of the plate;
b. a holder configured to receive the printing plate in a position to receive the radiation from the plurality of radiation sources;
c. means for causing relative movement (i) between the at least one front source and the printing plate in a movement direction orthogonal to the first dimension and (ii) between the printing plate and a non-irradiated area of the back side of the printing plate in the movement direction within an otherwise irradiated area coextensive with the back side of the printing plate; and
d. a controller configured to operate the plurality of radiation sources to expose the plate to the radiation, and to operate the means for causing relative movement, such that no cross-sectionally aligned, opposing portions of the front side and back side of the plate receive irradiation simultaneously from the at least one front source and the at least one back source.

2. The apparatus of claim 1, wherein the at least one back source comprises an array of sub-sources, and the controller is configured to operate the at least one front source to irradiate the front side of the plate along the movement direction, and to activate and inactivate a variable set of the sub-sources of the at least one back source synchronized with the relative motion of the at least one front source to cause irradiation of the back side of the printing plate except for in the non-irradiated area, wherein at least a portion of the non-irradiated area is cross-sectionally aligned with the opposing portion of the front side of the plate simultaneously irradiated by the at least one front source.

3. The apparatus of claim 1 or 2, further comprising:
a radiation shield opaque to the radiation from the plurality of radiation sources, the radiation shield positioned between at least a portion of the printing plate and at least a portion of the at least one back source, and
means for causing relative movement between the radiation shield and the printing plate;
wherein the controller is further configured to cause a first relative movement between the at least one front source and the printing plate in the movement direction, and to simultaneously cause a second relative movement between the radiation shield and the printing plate in the movement direction;
wherein optionally the radiation shield has a length extending in the movement direction beyond the irradiation field of the at least one front source;
wherein preferably the length of the radiation shield is adjustable in the movement direction; and optionally:
wherein the radiation shield is reconfigurable between a first state in which the radiation shield blocks a first percentage of the radiation from the at least one back source and a second state in which the radiation shield blocks a second percentage of the radiation from the at least one back source, wherein the first percentage is greater than that the second percentage;
wherein optionally the first percentage is a maximum percentage and the second percentage is a minimum percentage, and/or
wherein optionally the radiation shield comprises a plurality of louvers movable between a first configuration in which each louver blocks a maximum percentage of radiation between the at least one back source and the printing plate, and second configuration in which each louver blocks a minimum percentage of radiation between the at least one back source and the printing plate; and optionally:
wherein the radiation shield comprises two panels serially disposed between the at least one back source and the back side of the printing plate, the two panels defining an overlapping region in which respective portions of both panels are disposed between the at least one back source and the back side of the printing plate and at least one non-overlapping region in which only one of the two panels is disposed between the least one back source and the back side of the printing plate, at least one panel being laterally adjustable relative to the other panel to adjust an overall effective length of the radiation shield in which at least one panel is disposed between the at least one back source and the back side of the printing plate; or
wherein the radiation shield comprises at least two panels serially disposed between the at least one back source and the back side of the printing plate, the at least two panels defining an overlapping region in which respective portions of the panels are disposed between the at least one back source and the back side of the printing plate, each of the at least two panels having one or more linear perforations extending across at least a portion of the first dimension, at least one of the at least two panels being laterally adjustable between the first state in which respective perforations of the panels are aligned and the second state in which the respective perforations of the patents are not aligned.

4. The apparatus of claim 3, wherein the means for causing relative movement includes a first means for causing relative movement between the at least one front radiation source and the printing plate and a second means for causing relative movement between the radiation shield and the printing plate;
and optionally wherein the means for causing relative movement comprises at least one driving motor, and further comprises one or more components linking the first means and the second means selected from the group consisting of Bowden cables, magnetic elements, belts, or chains; and/or optionally
wherein the first means and the second means are independent from one another, and the controller is configured to synchronize the first means and the second means.

5. The apparatus of any one of claims 1-4, wherein the one or more radiation sources comprise a plurality of LED point sources configured to emit UV light; and/or
wherein the radiation shield comprises a UV-absorbing coating; and/or
wherein the holder comprises a substrate on which the plate is disposed, wherein the substrate is at least partially transparent to the radiation.

6. A process for exposing a printing plate comprising a photosensitive polymer activated by exposure to radiation from a plurality of radiation sources, the printing plate having a non-printing back side and a printing front side with a mask for defining an image to be printed, the plurality of radiation sources including at least one front source positioned to expose the front side of the plate to radiation and at least one back source positioned to expose the back side of the plate to radiation, the at least one front source having an irradiation field covering an area at least coextensive with a first dimension of the front side of the plate, the at least one back source having an irradiation field covering an area coextensive with the back side of the plate, the method comprising:
a. positioning a radiation shield opaque to the radiation from the plurality of radiation sources between at least a portion of the plate and at least a portion of the at least one back source, the radiation shield intervening between the irradiation field of the at least one front source and the at least one back source
b. irradiating the front side of the printing plate; and
c. irradiating an area of the back side of the printing plate not covered by the radiation shield, such that no cross-sectionally aligned, opposing portions of the front side and back side of the plate are irradiated simultaneously.

7. The process of claim 6, wherein the method further comprises causing a first relative movement between the at least one front source and the plate in a movement direction orthogonal to the first dimension, and simultaneously causing a second relative movement between the radiation shield and the plate in the movement direction, wherein optionally the radiation shield has a length extending beyond the irradiation field of the at least one front source in the movement direction, and further comprising adjusting the length of the radiation shield in the movement direction; and/or
further comprising selectively reconfiguring the radiation shield between a first state in which the radiation shield blocks the radiation from the at least one back source and a second state in which the radiation shield does not block the radiation from the at least one back source, and optionally comprising selecting the first state when the relative movement is progressing from a first location to a second location in a scanning direction, and selecting the second state when the relative movement is progressing to the first location from the second location in a direction opposite the scanning direction.

8. An apparatus for preparing a printing plate comprising a photosensitive polymer activated by exposure to radiation, the printing plate having a non-printing back side and a printing front side with a mask for defining an image to be printed, the apparatus comprising:
a plurality of radiation sources comprising at least one front source positioned to expose the front side of the plate to radiation and at least one back source positioned to expose the back side of the plate to radiation, the at least one front source having an irradiation field covering an area at least coextensive with a first dimension of the front side of the plate, the at least one back source comprising an array of sub-sources operable to produce an irradiation field covering an area coextensive with the back side of the plate;
a holder configured to receive the printing plate in a position to receive the radiation from the plurality of radiation sources;
means for causing relative movement between the at least one front source and the printing plate in a movement direction orthogonal to the first dimension; and
a controller configured to operate the plurality of radiation sources to expose the plate to the radiation, and to operate the means for causing relative movement,
wherein the controller is configured to operate the at least one front source to commence irradiating the front side of the plate, and operate the array of sub-sources of the at least one back source to commence irradiating an area of the back side of the printing plate which does not overlap with the irradiation field of the at least one front source, such that no cross-sectionally aligned, opposing portions of front side and back side of the plate are irradiated simultaneously.

9. An apparatus for preparing a printing plate comprising a photosensitive polymer activated by exposure to radiation, the printing plate having a non-printing back side and a printing front side with a mask for defining an image to be printed, the apparatus comprising:
a plurality of radiation sources comprising at least one front source positioned to expose the front side of the plate to radiation and at least one back source positioned to expose the back side of the plate to radiation, the at least one front source having an irradiation field covering an area at least coextensive with a first dimension of the front side of the plate, the at least one back source having an irradiation field covering an area coextensive with the back side of the plate;
a holder configured to receive the printing plate in a position to receive the radiation from the plurality of radiation sources;
means for causing relative movement between the at least one front source and the printing plate received by the holder in a movement direction orthogonal to the first dimension; and
a controller configured to operate the plurality of radiation sources to expose the plate to the radiation, and to operate the means for causing relative movement,
wherein a surface surrounding each of the at least one back source of the plurality of radiation sources is opaque to the radiation from the plurality of radiation sources.

10. The apparatus of claim 9, wherein the surface surrounding each of the at least one back source of the plurality of radiation sources is coated with a UV-absorbing coating.

11. A process for exposing a printing plate comprising a photosensitive polymer activated by exposure to radiation from a plurality of radiation sources, the printing plate having a non-printing back side and a printing front side with a mask for defining an image to be printed, the plurality of radiation sources including at least one front source positioned to expose the front side of the plate to radiation and at least one back source positioned to expose the back side of the plate to radiation, the at least one front source having an irradiation field covering an area at least coextensive with a first dimension of the front side of the plate, the at least one back source comprising an array of sub-sources operable to produce an irradiation field covering an area coextensive with the back side of the plate, the method comprising:
a. commencing irradiating the front side of the printing plate with the at least one front source while creating relative movement between the at least one front source and the printing plate in a movement direction; and
b. commencing irradiating one or more areas of the back side of the printing plate that do not overlap with the irradiation field of the at least one front source, by activating and inactivating a variable set of sub-sources to produce a non-irradiated area synchronized with the relative movement of the at least one front source, such that no cross-sectionally aligned, opposing portions of front side and back side of the plate are irradiated simultaneously.

12. A method for retrofitting an apparatus for preparing a printing plate comprising a photosensitive polymer activated by exposure to radiation, the printing plate having a non-printing back side and a printing front side with a mask for defining an image to be printed, the apparatus comprising:
a plurality of radiation sources comprising at least one front source positioned to expose the front side of the plate to radiation and at least one back source positioned to expose the back side of the plate to radiation, the at least one front source having an irradiation field covering an area at least coextensive with a first dimension of the front side of the plate, the at least one back source having an irradiation field covering an area coextensive with the back side of the plate;
a holder configured to receive the printing plate in a position to receive the radiation from the plurality of radiation sources;
means for causing relative movement between the at least one front source and the printing plate in a movement direction orthogonal to the first dimension; and
a controller configured to operate the plurality of radiation sources to expose the plate to the radiation, and to operate the means for causing relative movement,
wherein the method for retrofitting comprises the step of configuring the apparatus to produce a non-irradiated area of the back side of the printing plate in the movement direction synchronized with the relative movement between the at least one front source and the printing plate in the movement direction such that no cross-sectionally aligned, opposing portions of the front side and back side of the plate receive irradiation simultaneously from the at least one front source and the at least one back source.

13. The method of claim 12, wherein the at least one back source comprises an array of sub-sources, and the retrofitting step includes retrofitting the controller to synchronize the at least one back source to the relative motion of the at least one front source by activating and inactivating a variable set of sub-sources to produce the non-irradiated area synchronized with the relative movement of the at least one front source; and/or
wherein the retrofitting step includes (a) installing a radiation shield opaque to the radiation from the plurality of radiation sources, the radiation shield positioned between at least a portion of the printing plate and at least a portion of the at least one back source, (b) installing means for causing relative movement between the radiation shield and the printing plate, wherein the method optionally further comprises installing a linkage between the means for causing relative movement between the radiation shield and the printing plate and the means for causing relative movement between the at least one front source as the printing plate, and/or
wherein the means for causing relative movement between the radiation shield and the printing plate is independent of the means for causing relative movement between the at least one front source as the printing plate, further comprising configuring the controller to cause relative movement between the radiation shield and the printing plate in the movement direction synchronized with the relative movement between the at least one front source and the printing plate in the movement direction.

14. A process for exposing a printing plate comprising a photosensitive polymer activated by exposure to radiation from a plurality of radiation sources, the printing plate having a non-printing back side and a printing front side with a mask for defining an image to be printed, the plurality of radiation sources including at least one front source positioned to expose the front side of the plate to radiation and at least one back source positioned to expose the back side of the plate to radiation, the at least one front source comprising an array of front sub-sources operable to produce an irradiation field covering an area coextensive with the front side of the plate, the at least one back source comprising an array of back sub-sources operable to produce an irradiation field covering an area coextensive with the back side of the plate, the method comprising the sequential steps of:
a. commencing irradiating the back side of the printing plate by activating at least a portion of the array of back sub-sources sufficient to cover the area coextensive with the back side of the plate in its entirety;
b. after a predefined delay, commencing irradiating the front side of the printing plate by activating fewer than all of the front sub-sources to apply radiation covering a collective area less than coextensive with the front side of the plate; and
c. selectively inactivating back sub-sources cross-sectionally aligned with activated front sub-sources to produce a non-irradiated area synchronized with the activated front sub-sources, such that no cross-sectionally aligned, opposing portions of front side and back side of the plate are irradiated simultaneously.

15. An apparatus for preparing a printing plate comprising a photosensitive polymer activated by exposure to radiation, the printing plate having a non-printing back side and a printing front side with a mask for defining an image to be printed, the apparatus comprising:
at least one front radiation source positioned to expose the front side of the plate to radiation and comprising an array of front sub-sources operable to produce an irradiation field covering an area coextensive with the front side of the plate;
at least one back radiation source positioned to expose the back side of the plate to radiation and comprising an array of back sub-sources operable to produce an irradiation field covering an area coextensive with the back side of the plate;
a holder configured to receive the printing plate in a position to receive the radiation from the at least one front radiation source and the at least one back radiation source;
a controller configured to selectively operate the array of front sub-sources and the array of back sub-sources to perform the sequential steps of:
a. commencing irradiating the back side of the printing plate by activating at least a portion of the array of back sub-sources sufficient to cover the area coextensive with the back side of the plate in its entirety;
b. after a predefined delay, commencing irradiating the front side of the printing plate by activating fewer than all of the front sub-sources to apply radiation covering a collective area less than coextensive with the front side of the plate; and
c. selectively inactivating back sub-sources cross-sectionally aligned with activated front sub-sources to produce a non-irradiated area synchronized with the activated front sub-sources, such that no cross-sectionally aligned, opposing portions of front side and back side of the plate are irradiated simultaneously.
